# FASCICULE DE BREVET EUROPEEN

(11) **EP 2 084 736 B1**
(45) Date de publication et mention de la délivrance du brevet: **17.02.2010**
(21) Numéro de dépôt: 07847476.4
(22) Date de dépôt: 28.11.2007
(51) Int. Cl.: H01L 21/3105, H01L 21/762

(54) **PROCEDE DE REALISATION D'UN SUBSTRAT MIXTE**
VERFAHREN ZUR HERSTELLUNG EINES HYBRIDSUBSTRATS
METHOD OF FABRICATING A HYBRID SUBSTRATE

(30) Priorité: 29.11.2006 FR 0655193
(43) Date de publication de la demande: 05.08.2009
(73) Titulaire: Commissariat à l'Energie Atomique, 75015 Paris (FR)
(72) Inventeur: MORICEAU, Hubert, 38120 Saint Egreve (FR); SARTORI, Sylvie, 38240 Meylan (FR); CHARVET, Anne-Marie, 38450 Vif (FR)
(74) Mandataire: Ilgart, Jean-Christophe
(86) Numéro de dépôt international: PCT/EP2007/062959
(87) Numéro de publication internationale: WO 2008/065143

(56) Documents cités:
- FR-A- 2 876 220
- JP-A- 59 132 142
- US-A- 5 747 377
- US-A1- 2005 139 914
- US-B1- 6 599 812
- US-B2- 7 060 197

## Description

### DOMAINE TECHNIQUE

L'invention se rapporte à un procédé de réalisation d'un substrat mixte destiné à la fabrication de structures empilées spécifiques. Une telle structure empilée est obtenue par collage du substrat mixte avec un autre substrat ou une couche selon une interface de collage.

### ÉTAT DE LA TECHNIQUE ANTÉRIEURE

On est souvent amené, dans le domaine des semiconducteurs, à fabriquer des structures par empilement et collage. Par exemple, deux substrats peuvent être assemblés par collage moléculaire (ou « wafer bonding » en anglais) d'une face principale de l'un des substrats avec une face principale de l'autre substrat. Pour cela, les faces à mettre en contact doivent être soigneusement préparées pour permettre ce collage moléculaire. Cette préparation peut impliquer un polissage mécano-chimique des faces à mettre en contact, un nettoyage de ces faces et leur activation afin d'obtenir un contact intime (faces de qualité miroir).

Cette technique de collage moléculaire procure de très bons résultats pour le collage de substrats semiconducteurs présentant des faces homogènes quant à leur composition. Cependant, l'application de cette technique à des substrats présentant une face non homogène peut poser problème. De tels substrats sont appelés « substrats mixtes ». Ainsi, la face principale d'un substrat mixte (la face à coller) peut présenter au moins une zone de nature différente du reste du substrat. Un exemple de substrat mixte est constitué par un substrat de silicium possédant des pavés d'oxyde de silicium affleurant sur la face à coller du substrat, les pavés d'oxyde alternant avec des zones de silicium. Un autre exemple de substrat mixte est constitué par un substrat de silicium dont la face à coller présente une alternance de pavés fins d'oxyde et de pavés épais d'oxyde. Encore un autre exemple de substrat mixte est constitué par un substrat semiconducteur dont la face à coller présente une alternance de zones électriquement conductrices et de zones électriquement isolantes obtenues par dopage localisé et/ou inclusion de matériau plus ou moins conducteur.

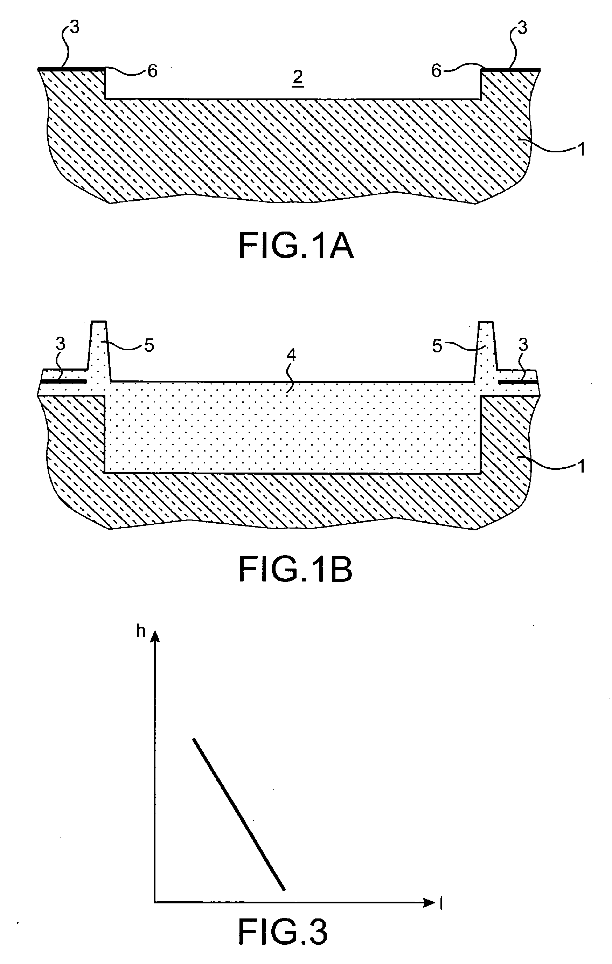

La préparation de surface d'un substrat mixte en vue de son collage moléculaire peut poser problème. A titre d'exemple, on va examiner le cas d'un substrat de silicium dont une face présente au moins un pavé d'oxyde de silicium affleurant. La réalisation d'un tel substrat va être décrite en relation avec les figures 1A et 1B. La figure 1A montre un substrat 1 en silicium dont l'une des faces principales a été gravée pour créer une cavité 2 (une seule cavité a été représentée, mais le substrat peut en comporter plusieurs). La face principale du substrat 1 est recouverte, en dehors de la cavité, d'un film 3 de nitrure de silicium servant de masque. Avantageusement, le film 3 de nitrure de silicium a été déposé sur le substrat 1 avant la réalisation de la cavité. Il peut même avoir servi de masque pour réaliser ladite cavité. On fait alors croître, par oxydation thermique, de l'oxyde de silicium jusqu'à combler la cavité. La figure 1B montre le résultat obtenu : un pavé d'oxyde de silicium 4 dans le substrat 1 en silicium. Le procédé mis en oeuvre provoque aussi la formation d'excroissances 5 en bord de cavité. Ces excroissances sont dues à la croissance de l'oxyde à partir de la zone supérieure 6 de la cavité 2 et à l'expansion de l'oxyde thermique par rapport au silicium. L'oxyde remplit la cavité et s'étend au-delà du fond initial de la cavité.

La figure 1B montre aussi la présence d'oxyde de silicium sur le film de nitrure 3. Ceci est dû au procédé d'oxydation qui provoque la consommation partielle du nitrure de silicium au cours de la réaction.

Le substrat mixte illustré par la figure 1B nécessite donc une préparation de surface (par polissage ou planarisation mécano-chimique) pour pouvoir coller, par adhésion moléculaire, la face du substrat mixte sur une face d'un autre substrat. En effet, pour obtenir un bon collage direct, il est nécessaire de supprimer au maximum les rugosités et les topologies présentes en surface.

Un problème souvent rencontré est celui d'une efficacité différente de ces planarisations sur les surfaces traitées : cette différence d'efficacité dépend par exemple de la répartition des topologies en surface ou par exemple encore de la nature des différents matériaux de la surface (sélectivité d'attaque lors de la planarisation mécano-chimique).

On remarque alors que certaines zones sont polies en excès par rapport à d'autres zones (phénomène dit de « dishing », en anglais). Ceci se traduit par de légères dépressions au niveau de la surface. On comprend bien que ces dépressions sont nuisibles à un contact intime avec une face plane d'un autre substrat et qu'ils génèrent des défauts de collage. En outre, après assemblage des deux substrats, si ces dépressions apparaissent sur des zones électriquement isolantes de l'un des substrats, il peut en résulter une dégradation de l'intégrité diélectrique des zones isolantes.

Les applications visées avec de telles structures collées supposent la réalisation de zones isolantes de plusieurs mm², voire de plusieurs cm². Ces zones isolantes sont générées dans des caissons de dimensions adaptées. Concernant la qualité des isolants, la raideur diélectrique doit être bonne suivant un axe perpendiculaire à la surface du substrat utilisé. Dans le cas de zones isolantes en oxyde de silicium, pour assurer une telle raideur diélectrique, il est préférable de produire cet isolant par oxydation thermique. L'épaisseur d'oxyde de silicium généré dans une cavité est de l'ordre de deux fois la profondeur initiale de la cavité réalisée dans le substrat de silicium.

Dans le cas où l'on désire des zones isolantes de grandes dimensions (de plusieurs mm², voire plusieurs cm²), les essais de planarisation de topologie sont en échec car on provoque un creusement de surface entre les excroissances à cause des grandes dimensions des pavés à obtenir. Il en résulte des défauts de planéité induits qui empêchent un collage ultérieur, même si la rugosité de surface sur des dimensions de l'ordre du micromètre est satisfaisante.

Le brevet US 5 747 377 divulgue un procédé de formation de tranchées isolantes peu profondes sur une face d'un substrat de silicium. Pour former des régions d'oxyde de champ, il est proposé de réaliser des séries de tranchées dans le substrat. Les tranchées correspondant à une même future région sont séparées par des murs dont la largeur est de l'ordre de grandeur des tranchées. On procède ensuite à l'oxydation des murs (oxydation latérale) en vue de combler les tranchées. Dans ce cas, le temps d'oxydation est beaucoup plus faible que si l'on partait d'une simple cavité sans murs. Cependant, l'isolation électrique peut être défectueuse verticalement. De plus, le procédé divulgué par le brevet US 5 747 377 est destiné particulièrement à la réalisation de régions d'oxyde de champ pour transistors CMOS. Il implique une densité de murs trop importante pour permettre une planarisation avec un faible enlèvement de matière. La rugosité des zones isolantes créées à partir des tranchées peut être traitée sur des dimensions micrométriques mais pas sur des échelles millimétriques.

### EXPOSÉ DE L'INVENTION

La présente invention a été conçue en vue de remédier aux inconvénients de l'art antérieur cités ci-dessus.

La présente invention propose un procédé de réalisation d'un substrat mixte dans lequel les cavités sont formées avec des saillies régulièrement espacées, permettant de diminuer fortement la rugosité de surface. La densité et les dimensions latérales des saillies sont limitées de façon à pouvoir planariser efficacement la totalité des saillies en enlevant un minimum de matière en surface du substrat structuré. La distance séparant les saillies est de l'ordre de la centaine de micromètres et la largeur des saillies est de l'ordre de 0,1 à 6 µm.

L'invention a pour objet un procédé de réalisation d'un substrat mixte, c'est-à-dire un substrat comprenant au moins un caisson en matériau différent du matériau du substrat, le caisson étant de grandes dimensions, c'est-à-dire d'au moins plusieurs mm², le procédé comprenant les étapes successives suivantes :
- formation dans un substrat de premier matériau, et à partir de l'une de ses faces, d'une cavité,
- formation du caisson au moyen d'une réaction, initiée à partir des parois de la cavité, entre le premier matériau et au moins un élément chimique apporté pour obtenir un deuxième matériau remplissant la cavité,
- planarisation de ladite face du substrat, caractérisé en ce que :
- l'étape de formation de la cavité est menée de façon à laisser subsister des parties de premier matériau faisant saillie à partir du fond de la cavité, ces parties de premier matériau (12) ayant une largeur comprise entre 0.1 µm et 6 µm et étant espacées d'une distance de l'ordre de 100 µm,
- l'étape de formation du caisson est menée de façon à obtenir, à partir des parties de premier matériau faisant saillie, des excroissances de second matériau faisant saillie sur ladite face du substrat.

Selon une première variante, les parties du premier matériau faisant saillie sont constituées par des mur ou des piliers faisant saillie à partir du fond de la cavité.

Selon une deuxième variante, l'étape de formation de la cavité est menée de façon à laisser subsister plusieurs parties de premier matériau faisant saillie et délimitant plusieurs alvéoles dans la cavité.

L'étape de planarisation peut être réalisée par polissage mécano-chimique ou mécanique.

Selon une application particulière, le substrat étant en silicium, une oxydation thermique du silicium est mise en oeuvre pour former un caisson d'oxyde de silicium.

Selon une autre application particulière, le substrat étant en SiGe, une oxydation thermique du SiGe est mise en oeuvre pour former un caisson de SiGe oxydé.

Selon encore une autre application particulière, le substrat étant en silicium, une nitruration du silicium est mise en oeuvre pour former un caisson de SiN.

Le procédé peut encore comprendre, entre l'étape de formation de la cavité et l'étape de formation du caisson, une étape de masquage des parties du substrat ne devant pas subir ladite réaction.

Après l'étape de planarisation, il peut être prévu une étape de collage d'un film mince sur la face planarisée du substrat.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A et 1B, déjà décrites, sont des vues en coupe illustrant un procédé de réalisation d'un substrat mixte selon l'art antérieur,
- les figures 2A à 2C sont des vues en coupe illustrant un procédé de réalisation d'un substrat mixte selon l'invention,
- la figure 3 est un diagramme de principe représentant la hauteur d'espaceur oxydée en fonction de la largeur d'un espaceur.

### EXPOSÉ DÉTAILLÉ DE MODES DE RÉALISATION PARTICULIERS

A titre d'exemple, dans ce qui suit le substrat initial sera en silicium et le caisson sera en oxyde de silicium. La réaction utilisée pour obtenir le caisson sera une oxydation thermique du silicium formant le substrat initial, cette oxydation étant initiée au niveau de la cavité formée dans le substrat initial.

Les figues 2A à 2C illustrent un procédé de réalisation d'un substrat mixte selon l'invention.

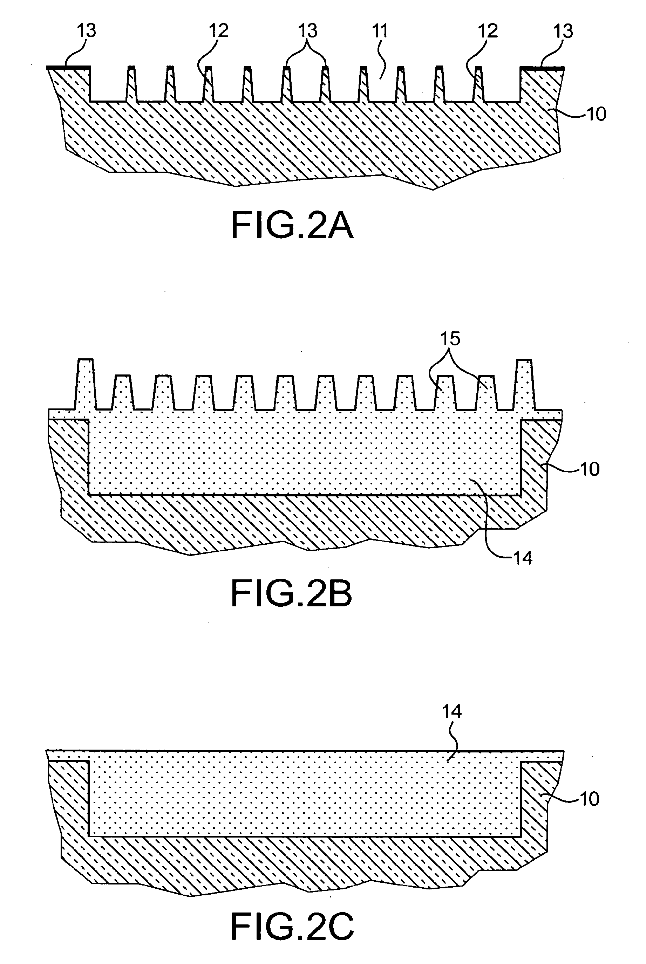

La figure 2A représente un substrat 10 en silicium sur lequel on a avantageusement déposé une couche de nitrure de silicium 13 sur l'une de ses faces principales. En variante, cette couche pourrait être déposée après la réalisation de la cavité. A partir de cette même face principale, on a formé, par gravure, une cavité 11, la couche 13 pouvant avantageusement servir de masque de gravure pour la réalisation de cette cavité. La gravure a été réalisée de façon à laisser subsister dans la cavité 11 des parties 12 faisant saillie du fond de la cavité. Les parties 12 sont par exemple des piliers ou des murs. Leur nombre, leur espacement et leur taille sont prévus, en fonction de la dimension de la cavité pour empêcher ou limiter le phénomène de « dishing » résultant d'une planarisation mécano-chimique ultérieure. Les caractéristiques des parties 12 (nombre, espacement, taille) peuvent être évaluées au cours de tests.

On cherchera avantageusement à ce que, après oxydation thermique, les piliers de silicium soient complètement oxydés au niveau de la cavité 11. La largeur de ces piliers sera notamment corrélée à l'épaisseur d'oxyde que l'on souhaite générer. Plus cette épaisseur sera grande, plus les piliers pourront être larges.

Le film 13 de nitrure de silicium ne recouvre pas la cavité 11 et les parties 12 qui appartiennent à la cavité. Cependant, il est présent sur les sommets des parties 12.

On procède alors à l'oxydation thermique du silicium de la cavité, c'est-à-dire à l'oxydation du fond, des parois de la cavité et des parois des parties 12 de la cavité. L'oxydation est avantageusement menée jusqu'à obtenir la structure représentée à la figure 2B et qui montre un caisson d'oxyde de silicium 14 formé à partir de la cavité et hérissé d'excroissances 15 également en oxyde de silicium. L'oxydation a été avantageusement menée de façon à transformer totalement les parties 12 (voir la figure 2A) en oxyde de silicium. Cependant, il pourrait selon l'application, subsister un peu des parties 12 en silicium.

Sur la figure 2B, on remarque que la couche de nitrure a été intégralement consommée pendant l'oxydation. En variante, il pourrait subsister une partie de cette couche de nitrure, surmontée d'oxyde de silicium.

L'étape suivante consiste à planariser la face principale du substrat, par exemple par polissage mécano-chimique. Le polissage permet d'éliminer les excroissances 15 et de planariser la face principale du substrat 10. Le caisson 14 présente une face plane avec un « dishing » minimisé, compatible en terme de planéité avec le collage d'un film mince par exemple en silicium.

### Exemple-d'application 1

A la surface d'un substrat de silicium, une cavité est gravée. Cette cavité (référencée 11 sur la figure 2A) est constituée d'un ensemble de sous-cavités ou alvéoles séparées par des parties ou parois ou murs (référencés 12 sur la figure 2A) s'élevant du fond de la cavité. La cavité a une profondeur de 1,5 µm. Les alvéoles ont une largeur de 100 µm. Les parois ou murs de séparation des alvéoles ont 2 µm d'épaisseur.

On produit 3 µm d'oxyde de silicium au niveau de la zone gravée, par oxydation thermique à 1100°C sous vapeur d'eau. La zone du substrat située en dehors du futur caisson isolant est protégée par un film de nitrure de silicium pour éviter son oxydation. On observe alors que les murs de séparation des alvéoles sont oxydés sur une hauteur dépendant de la largeur initiale de ces murs et de l'épaisseur d'oxyde généré. Avantageusement, on choisira les dimensions de ces murs (et notamment l'épaisseur) de sorte que les murs soient oxydés sur toute leur hauteur initale. On observe aussi, à l'aplomb de ces parois, des excroissances de 0,8 µm de hauteur. Au bord de la cavité, les excroissances ont une hauteur comprise entre 1 µm et 1,2 µm.

La planarisation mécano-chimique est effectuée et caractérisée en particulier à l'aplomb des futures zones isolantes. Si on compare la valeur moyenne du « dishing » obtenu sur des zones « classiques », c'est-à-dire non protégées par les excroissances, et sur des zones « protégées » par des excroissances, on constate que le « dishing » est effectivement bien réduit grâce à la présence des excroissances.

Par exemple lors d'un procédé de planarisation d'excroissances de bord de 1,1 µm de hauteur et pour des zones isolantes de surface voisines de 3 mm x 3 mm, on obtient un « dishing » supérieur à 50 nm si les zones n'ont pas d'excroissances de protection alors qu'avec des excroissances le « dishing » est réduit à moins de 50 nm, voire à moins de 10 nm. Le substrat obtenu peut ensuite être collé au niveau de cette face, après éventuellement une préparation de surface adaptée, à un film mince de silicium pour former un substrat mixte présentant des zones SOI et des zones massives.

### Exemple d'application 2

A la surface d'un substrat de silicium, une cavité est gravée. Cette cavité (référencée 11 sur la figure 2A) est constituée d'un ensemble de sous-cavités ou alvéoles séparées par des parties ou parois ou murs (référencés 12 sur la figure 2A) s'élevant du fond de la cavité. La cavité a une profondeur de 1,5 µm. Les alvéoles ont une largeur de 100 µm. Les parois ou murs de séparation des alvéoles ont 4 µm d'épaisseur.

On produit 3 µm d'oxyde de silicium dans la zone gravée, par oxydation thermique à 1100°C sous vapeur d'eau. La zone du substrat située en dehors du futur caisson isolant est protégée par un film de nitrure de silicium pour éviter son oxydation. On observe alors que les parois de séparation des alvéoles sont totalement oxydées sur une hauteur de 0,5 µm. On observe aussi, à l'aplomb de ces parois, des excroissances de 0,7 µm de hauteur. Au bord de la cavité, les excroissances ont une hauteur comprise entre 1 µm et 1,2 µm.

Après polissage et préparation de surface, ce substrat peut être assemblé avec un film mince de silicium oxydé en surface pour former un substrat SOI avec des zones d'oxyde de différentes épaisseurs.

### Exemple d'application 3

A la surface d'un substrat de silicium, une cavité est gravée. Cette cavité est constituée d'un ensemble d'alvéoles séparées par des parois ou espaceurs s'élevant du fond de la cavité. La cavité a une profondeur de 1,5 µm. Les alvéoles ont une largeur de 100 µm. Les parois de séparation des alvéoles ont 2 µm d'épaisseur.

La zone située hors du futur caisson isolant est alors couverte d'un film d'oxyde de silicium obtenu par exemple par voie thermique, par voie chimique ou par voie sèche type plasma ou UV/O₃ dit film piédestal. L'épaisseur de ce film est inférieure à 0,5 µm, de préférence inférieure à 50 nm et de préférence encore inférieure à 20 nm. Ce film d'oxyde est protégé par un film de nitrure de silicium destiné à former barrière à une oxydation ultérieure.

On produit 3 µm d'oxyde de silicium dans la zone gravée, par oxydation thermique à 1100°C sous vapeur d'eau. On observe alors que les parois de séparation des alvéoles sont totalement oxydées sur une hauteur de 2 µm. On observe aussi, à l'aplomb de ces parois, des excroissances de 0,8 µm de hauteur. Au bord de la cavité, les excroissances ont une hauteur comprise entre 1 µm et 1,2 µm.

La planarisation mécano-chimique est effectuée et caractérisée en particulier à l'aplomb des futures zones isolantes. Si on compare la valeur moyenne du « dishing » obtenu sur des zones « classiques », c'est-à-dire non protégées par les excroissances, et sur des zones « protégées » par des excroissances, on constate que le « dishing » est effectivement bien réduit grâce à la présence des excroissances. Il est supérieur à 50 nm au niveau des zones « classiques » et de l'ordre de 5 nm au niveau des zones « protégées ».

Par exemple lors d'un procédé de planarisation d'excroissances de bord de 1,1 µm de hauteur et pour des zones isolantes de surface voisines de 3 mm x 3 mm, on obtient un « dishing » supérieur à 50 nm si les zones n'ont pas d'excroissances de protection alors qu'avec des excroissances le « dishing » est réduit à moins de 5 nm.

Cet exemple peut être décliné avec plusieurs épaisseurs d'oxyde, avec diverses formes de parties faisant saillie (espaceurs, murs, parois, piliers), avec différentes largeurs d'espaceurs, avec des espaceurs dont la largeur varie en fonction de la hauteur (forme trapézoïdale), le sommet des parties faisant saillie pouvant être plus large que leur base (comme montré sur la figure 2A) ou au contraire moins large.

La largeur des espaceurs sera d'autant plus petite que le temps d'oxydation, et donc l'épaisseur d'oxyde du futur caisson isolant, est faible.

La largeur des espaceurs sera d'autant plus petite que la hauteur oxydée des espaceurs est grande. Le diagramme de principe de la figure 3 illustre cet aspect. Sur ce diagramme, l'axe des ordonnées représente la hauteur h oxydée dans les espaceurs et l'axe des abscisses représente la largeur 1 des espaceurs.

L'invention s'applique également à l'oxydation thermique de SiₓGe_{y} ou à la nitruration de silicium, mais pour des cavités de plus faible profondeur car la nitruration consomme beaucoup moins de silicium que l'oxydation.

## Revendications

1. Procédé de réalisation d'un substrat mixte, c'est-à-dire un substrat comprenant au moins un caisson en matériau différent du matériau du substrat, le caisson étant de grandes dimensions, c'est-à-dire d'au moins plusieurs mm², le procédé comprenant les étapes successives suivantes :
- formation dans un substrat de premier matériau (10), et à partir de l'une de ses faces, d'une cavité
- formation du caisson (14) au moyen d'une réaction, initiée à partir des parois de la cavité (11), entre le premier matériau et au moins un élément chimique apporté pour obtenir un deuxième matériau remplissant la cavité (11),
- planarisation de ladite face du substrat,
**caractérisé en ce que** :
- l'étape de formation de la cavité (11) est menée de façon à laisser subsister des parties de premier matériau (12) faisant saillie à partir du fond de la cavité, ces parties de premier matériau (12) ayant une largeur comprise entre 0,1 µm et 6 µm et étant espacées d'une distance de l'ordre de 100 µm,
- l'étape de formation du caisson est menée de façon à obtenir, à partir des parties de premier matériau (12) faisant saillie, des excroissances de second matériau (15) faisant saillie sur ladite face du substrat(10).

2. Procédé selon la revendication 1, dans lequel les parties du premier matériau (12) faisant saillie sont constituées par des murs ou des piliers faisant saillie à partir du fond de la cavité.

3. Procédé selon la revendication 1, dans lequel l'étape de formation de la cavité est menée de façon à laisser subsister plusieurs parties de premier matériau faisant saillie et délimitant plusieurs alvéoles dans la cavité.

4. Procédé selon la revendication 1, dans lequel l'étape de planarisation est réalisée par polissage mécano-chimique ou mécanique.

5. Procédé selon l'une quelconque des revendications 1 à 4, dans lequel, le substrat (10) étant en silicium, une oxydation thermique du silicium est mise en oeuvre pour former un caisson d'oxyde de silicium (14).

6. Procédé selon l'une quelconque des revendications 1 à 4, dans lequel, le substrat étant en SiGe, une oxydation thermique du SiGe est mise en oeuvre pour former un caisson de SiGe oxydé.

7. Procédé selon l'une quelconque des revendications 1 à 4, dans lequel, le substrat étant en silicium, une nitruration du silicium est mise en oeuvre pour former un caisson de SiN.

8. Procédé selon l'une quelconque des revendications 1 à 7, comprenant, entre l'étape de formation de la cavité et l'étape de formation du caisson, une étape de masquage des parties du substrat ne devant pas subir ladite réaction.

9. Procédé selon l'une quelconque des revendications 1 à 8, dans lequel, après l'étape de planarisation, il est prévu une étape de collage d'un film mince sur la face planarisé du sustrat.

## Claims

1. Method of producing a mixed substrate, that is to say a substrate comprising at least one well of material different from the material of the substrate, the well being of large size, that is at least several mm², the method comprising the following successive steps:
- formation of a cavity (11) in a substrate of first material (10), and from one of its faces,
- formation of the well (14) by means of a reaction, initiated from the walls of the cavity (11), between the first material and at least one chemical element brought in order to obtain a second material filling the cavity (11),
- planarizing said first face of the substrate,
**characterised in that**:
- the step of forming the cavity (11) is carried out so as to leave at least parts of the first material (12) projecting from the bottom of the cavity, these parts of first material (12) having a width between 0.1 µm and 6 µm and being spaced apart from a distance about 100 µm,
- the well formation step is carried out so as to obtain, from the parts of the first material (12) projecting, protrusions of second material (15) projecting on said face of the substrate (10).

2. Method according to claim 1, wherein the parts of the first material (12) projecting are formed by walls or pillars projecting from the bottom of the cavity.

3. Method according to claim 1, wherein the step of forming the cavity is carried out so as to leave several parts of the first material projecting and delimiting several alveoli in the cavity.

4. Method according to claim 1, wherein the planarizing step is carried out by chemical-mechanical or mechanical polishing.

5. Method according to any one of claims 1 to 4, wherein, the substrate (10) being made from silicon, a thermal oxidation of the silicon is implemented in order to form a well of silicon oxide (14).

6. Method according to any one of claims 1 to 4, wherein, the substrate being made from SiGe, a thermal oxidation of the SiGe is implemented in order to form a well of oxidised SiGe.

7. Method according to any one of claims 1 to 4, wherein, the substrate being made from silicon, a nitriding of the silicon is implemented in order to form a well of SiN.

8. Method according to any one of claims 1 to 7, comprising, between the step of forming the cavity and the step of forming the well, a step of masking parts of the substrate that are not to undergo said reaction.

9. Method according to any one of claims 1 to 8, wherein, after the planarizing step, a step of bonding a thin film on the planarized face of the substrate is provided.

## Patentansprüche

1. Verfahren zur Herstellung eines Hybridsubstrats, das heißt eines Substrats mit wenigstens einer ein anderes Material als das Material des Substrats umfassenden Wanne, wobei die Wanne große Dimensionen aufweist, das heißt wenigstens mehrere mm², und das Verfahren die folgenden sukzessiven Schritte umfasst:
- Bildung eines Hohlraums (11) in einem Substrat aus einem ersten Material (10) auf einer seiner Seiten,
- Bildung der Wanne (14) mittels einer an den Wänden des Hohlraums (11) initiierten Reaktion zwischen dem ersten Material und wenigstens einem eingebrachten chemischen Element, um ein zweites, den Hohlraum (11) füllendes Material zu erzeugen,
- Planarisierung der genannten Seite des Substrats,
**dadurch gekennzeichnet:**
- **dass** der Schritt zur Bildung des Hohlraums (11) so durchgeführt wird, dass vom Boden des Hohlraums emporragende Teile aus dem ersten Material (12) stehen bleiben, wobei diese Teile aus dem ersten Material (12) eine Breite zwischen 0,1 µm und 6 µm und einen Abstand voneinander in der Größenordnung von 100 µm haben,
- **dass** der Schritt zur Bildung der Wanne so durchgeführt wird, dass man - ausgehend von den emporragenden Teilen aus dem ersten Material (12) - auf der genannten Seite des Substrats (10) Auswüchse aus einem zweiten Material (15) erhält.

2. Verfahren nach Anspruch 1, bei dem die emporragenden Teile des ersten Materials (12) durch vom Boden des Hohlraums emporragende Mauern oder Säulen gebildet werden.

3. Verfahren nach Anspruch 1, bei dem der Schritt zur Bildung des Hohlraums so durchgeführt wird, dass mehrere emporragende und mehrere Zellen in dem Hohlraum begrenzende Teile aus dem ersten Material stehen bleiben.

4. Verfahren nach Anspruch 1, bei dem der Planarisierungsschritt durch mechanisch-chemisches oder mechanisches Polieren realisiert wird.

5. Verfahren nach einem der Ansprüche 1 bis 4, bei dem das Substrat (10) aus Silicium ist und eine thermische Oxidation des Siliciums durchgeführt wird, um eine Siliciumoxidwanne (14) zu bilden.

6. Verfahren nach einem der Ansprüche 1 bis 4, bei dem das Substrat aus SiGe ist und eine thermische Oxidation des SiGe durchgeführt wird, um eine Wanne aus oxidiertem SiGe zu bilden.

7. Verfahren nach einem der Ansprüche 1 bis 4, bei dem das Substrat aus Silicium ist, wobei ein Nitrieren des Siliciums durchgeführt wird, um eine Wanne aus SiN zu bilden.

8. Verfahren nach einem der Ansprüche 1 bis 7, umfassend - zwischen dem Schritt zur Bildung des Hohlraums und dem Schritt zur Bildung der Wanne - einen Schritt zur Maskierung der Teile des Substrats, die nicht der genannten Reaktion ausgesetzt werden dürfen.

9. Verfahren nach einem der Ansprüche 1 bis 7, bei dem, nach dem Planarisierungsschritt, ein Schritt des Aufklebens eines Dünnfilms auf die planarisierte Seite des Substrats vorgesehen ist.
